# EUROPÄISCHE PATENTSCHRIFT

(11) **EP 1 574 044 B1**
(45) Veröffentlichungstag und Bekanntmachung des Hinweises auf die Patenterteilung: **11.01.2017**
(21) Anmeldenummer: 03778331.3
(22) Anmeldetag: 21.11.2003
(51) Int. Cl.: H04N 5/225, H05K 1/14

(54) **BILDERZEUGUNGSVORRICHTUNG, INSBESONDERE ZUM EINBAU IM DACHBEREICH ODER IM AUSSENSPIEGEL EINES KRAFTFAHRZEUGES**
IMAGE GENERATION DEVICE, PARTICULARLY FOR INSTALLATION IN THE ROOF AREA OR IN THE EXTERIOR REARVIEW MIRROR OF A MOTOR VEHICLE
DISPOSITIF DE FORMATION D'IMAGE, A MONTER NOTAMMENT DANS LA ZONE DU TOIT OU DANS LE RETROVISEUR EXTERIEUR D'UNE AUTOMOBILE

(30) Priorität: 19.12.2002 DE 10259795
(43) Veröffentlichungstag der Anmeldung: 14.09.2005
(73) Patentinhaber: Continental Automotive GmbH, 30165 Hannover (DE)
(72) Erfinder: BELAU, Horst, 84085 Langquaid (DE)
(86) Internationale Anmeldenummer: PCT/EP2003/013096
(87) Internationale Veröffentlichungsnummer: WO 2004/057857

(56) Entgegenhaltungen:
- EP-A- 0 541 449
- WO-A-03/005455
- DE-A- 19 929 754
- DE-C- 19 701 854
- US-A1- 2001 055 073
- PATENT ABSTRACTS OF JAPAN vol. 2002, no. 07, 3. Juli 2002 (2002-07-03) & JP 2002 077678 A (NEC CORP;NEC ROBOTICS ENG LTD), 15. März 2002 (2002-03-15)

## Beschreibung

Die Erfindung betrifft eine Bilderzeugungsvorrichtung, insbesondere zum Einbau in den Dachbereich eines Kraftfahrzeuges zwecks Erfassung eines Objektes wie eine Person oder eines charakteristischen Elements wie die Seitenfläche eines Fahrzeugsitzes im Innenraum des Fahrzeuges; zum Einbau in den Außenspiegel eines Kraftfahrzeuges zwecks Erfassung eines Gegenstandes bzw. Fremdfahrzeuges auf der benachbarten Fahrbahnspur; oder dergleichen mehr.

Als Einbauort für Bilderzeugungsvorrichtungen wie Mono- oder 3D-Kameras zum Erfassen eines Objektes oder Elements im Innenraum eines Fahrzeuges ist bevorzugt der Dachbereich im Auto vorgesehen. Gleichartige Kameras zum Erfassen eines Gegenstandes z.B. zwecks Assistierung beim Spurwechsel werden bevorzugt in den Außenspiegel eines Kraftfahrzeugs eingebaut.

Eine gattungsbildende Vorrichtung der eingangs genannten Art ist beispielsweise aus der US 2001/055073A1 bekannt. Diese beschreibt eine Bilderzeugungsvorrichtung, umfassend ein Festkörper-Abbildungselement eine optische Linse, die von einem Rahmen gehalten ist und eine flexible Leiterplatte, die zwei Oberflächen hat, wobei das Festkörper-Abbildungselement an der einen Oberfläche der flexiblen Leiterplatte und der Rahmen an ihrer anderen Oberfläche angebracht ist.

Eine weitere ähnliche Vorrichtung ist aus der JP 2002 077678A bekannt, welche eine Kameravorrichtung für ein Kraftfahrzeug offenbart, die ein flexible Leiterplatte umfasst, wobei die Leiterplatte eine Sandwich-Struktur aufweist. In dieser Sandwich-Struktur sind leitende Schicht und isolierende Schicht abwechselnd angeordnet.

Problematisch ist in beiden Fällen zunächst die Gewährleistung einer in Lage und Richtung ortsfesten Fixierung von Optik und Bildaufnahmesensor einerseits sowie - bei einer 3D-Kamera - zweier derartiger Optikmoduln zueinander andererseits. Insbesondere dürfen die Optiken zueinander sich weder bewegen noch schwingen, was bei einer Vielzahl an Erschütterungen, denen ein Kraftfahrzeug gewöhnlich ausgesetzt ist, keine vernachlässigbare Größe darstellt.

So ist bekannt, das Optikmodul mit dem Gehäuse der Bilderzeugungsvorrichtung starr zu verbinden, um eine entsprechende Fixierung bzw. Justierung zu gewährleisten. Die schaltungstechnische Anbindung des Optikmoduls erfolgt zuvor gewöhnlich mittels einer flexiblen Platine in Flip-Chip-Technologie. Dabei wird die später mit dem Gehäuse starr verbundene Optik vor dem offenen Fenster mit dahinter liegendem Bildaufnahmesensor sensor platziert. Die sogenannten Flex-Folien vermeiden nicht nur Steckverbindungselemente, sondern erlauben in vorteilhafter Weise aufgrund ihrer flexiblen Ausgestaltung die Anbindung mehrerer starr fixierter Optikmoduln an eine einzige Platine. Jedoch sind hochkomplexe Halbleiterbauteile mit vielen Verbindungen und definierten Leiterbahn-Impedanzen hierbei nicht realisierbar. Diese Komponenten müssen auf einer weiteren Platine untergebracht werden. Die Montage einer derartig ausgebildeten Bilderzeugungsvorrichtung ist eher als aufwendig einzustufen. Darüber hinaus ist bei Flex-Folien die Wärmeabfuhr wegen des hohen Wärmewiderstandes von etwa 120 K/W problembehaftet. Dies liegt zum einen an der Aussparung der aktiven optischen Fläche (Fenster in der Platine) und an fehlenden Kupferflächen (kein mehrlagiger Platinenaufbau). Darüber hinaus lassen sich keine Kühlelemente vorsehen, weil diese die Vorteile von Flex-Folien minimieren würden.

Eine Sicherstellung der Wärmeabfuhr wirkt sich jedoch entscheidend auf die Bildqualität der Bilderzeugungsvorrichtung auf. Diese ist um so schlechter, je höher die Temperatur ist, bzw. um so besser, je kälter die Optikmoduln bleiben. Neben dem Bildaufnahmesensor selbst sind der Mikroprozessor sowie weitere hochkomplexe elektronische Bauteile Wärmequellen der Bilderzeugungsvorrichtung. Erhöhte Temperaturanforderung aufgrund von Sonneneinstrahlung bis ca. 105°C Umgebungstemperatur für die Optikmoduln treten erschwerend hinzu. Insbesondere bei der 3D-Kamera ist aus wärmetechnischen Überlegungen ein Einbau im Dachbereich bzw. Außenspiegel fast ausgeschlossen. Und auch mit der konventionellen Leiterplattentechnik ist es fertigungstechnisch äußerst schwierig, die entsprechenden Wärmemengen abzuführen. Die Wärmeabfuhr ist bisher noch nicht gelöst.

Hinzu kommt schließlich der begrenzte Einbauraum im Dachhimmel wie auch im Außenspiegel, wenn die gesamte Elektronik der Bilderzeugungsvorrichtung beispielsweise aus Kosten- und Fertigungsgesichtspunkten in einem Gehäuse angeordnet sein soll.

Die Abmessungen sind für den gegenwärtigen Bauraum im Fahrzeug zu groß. Eine andere genau definierte geometrische Ausbildung oder Aufteilung der Komponenten, bis hin zu Lösungen mit einem Zentralgerät im Innenraum des Kraftfahrzeuges und einem Optikmodul, beispielsweise umfassend einen CMOS-Bildaufnahmesensor (CMOS = Complementary Metal Oxide Semiconductor / komplementärer Metalloxid-Halbleiter), im Dachhimmel bzw. Außenspiegel sind nicht nur teuer sondern auch aufwendig. Insbesondere kann die Leitungslänge nicht beliebig lang sein, weil die Treiberleistung regelmäßig begrenzt ist. So sind bei diesen Satelliten-Lösungen neben den bekannten sog. Surface Mount Devices (SMD)-Komonenten bzw. Chip-Carrier wie Kondensatoren, Transistoren, Widerstände, Spulen, etc. insb. Steckerelemente vorzusehen. Hinzu kommt, dass bei der bekannten SMD-Technologie die Bauteile bzw. Chip-Carrier flach auf die Leiterplatte montiert und die elektrischen Anschlüsse der Chip-Carrier durch Anschlussdrähte direkt auf der Oberfläche mit den Leiterzügen verbunden werden. Als elektrische Anschlüsse der Bauteile dienen metallisierte Flächen oder Anschlussdrähte, die flach auf der Leiterplatte aufliegen. Die Fixierung der Bauteile erfolgt entweder mit Klebstoffen (bei anschließendem Schwallötverfahren), oder mit Lotpasten beim sog. Reflowlöten. Diese Technologie unterliegt immanent der Gefahr des Vertauschens von Anschlüssen zu Lasten der Verbindungssicherheit.

Der vorliegenden Erfindung liegt daher die Aufgabe zugrunde, eine verbesserte, die vorgenannten Probleme weitgehendst vermeidende Bilderzeugungsvorrichtung zum Einbau in den Dachbereich eines Kraftfahrzeuges zwecks Erfassung eines Objektes bzw. eines Elements im Innenraum eines Fahrzeuges oder zum Einbau im Außenspiegel eines Kraftfahrzeuges zwecks Erfassung eines Gegenstandes bzw. Fremdfahrzeuges auf der benachbarten Fahrbahnspur bereitzustellen. Insbesondere sollen mehrere der zum Teil sich widersprechenden Rahmenparameter wie eine Steifigkeit innerhalb und/oder zwischen den Optikmoduln, eine gute thermische Anbindung an den Fahrgastraum, eine minimale Bauhöhe zumindest im Bereich der Optikmoduln, eine gute Montagefreundlichkeit und/oder dergleichen, zugleich verbessert werden.

Diese Aufgabe wird erfindungsgemäß durch eine Bilderzeugungsvorrichtung mit den Merkmalen des Patentanspruchs 1 gelöst. Vorteilhafte Ausgestaltungen und Weiterbildungen, welche einzeln oder in Kombination miteinander eingesetzt werden können, sind Gegenstand der abhängigen Ansprüche.

Erreicht wird dies bei einer Bilderzeugungsvorrichtung der eingangs genannten Art durch eine erste Platine für hochkomplexe Halbleiter wie Mikro-Controller, Speicher, etc. mit wenigstens einen optischen Bildaufnahmesensor; und eine zweite Platine für alle anderen Bauteile wie insb. große Kondensatoren, Transistoren, Widerstände, Spulen, Stecker etc. Das Vorsehen der gesamten Elektronik auf zwei Platinen erlaubt in vorteilhafter Weise eine Gruppierung der Bauteile beispielsweise nach Gehäusevolumen oder Integrationsgrad und damit die Fertigung von Platinen mit vorteilhaft kleineren Abmessungen. Diese haben zudem exakt reproduzierbare Hochfrequenzeigenschaften innerhalb einer Schaltung, insbesondere bei LVDS (Low Voltage Differential Signaling) High-Speed-Leitungen wie z.B. zwischen Mikro-Controller und einem Speichermodul, beispielsweise einem SIRAM, durch genau definierte geometrische Ausbildung der Einzelelemente zum Vorteil. Die Anordnung von erster und/oder zweiter Platine auf einer metallischen Grundplatte verbessert in vorteilhafter Weise die Wärmeableitung erheblich. Gleiches gilt, wenn die Platinen mit der Grundplatte verklebt werden. In diesem Fall sind zudem vorteilhaft keine Verschraubungen mehr erforderlich. Darüber hinaus sorgt die Grundplatte zusätzlich für hinreichend gute Steifigkeit und Ebenheit der Platinen-Moduln. Insbesondere letztgenanntes Kriterium ist Vorraussetzung für eine korrekte, im Fall einer 3D-Kamera parallelen, Justierung bzw. Ausrichtung der optischen Achse(n). Indem das Gehäuse keinen Beitrag mehr zur Steifigkeit liefert, besteht keine Notwendigkeit auf flexible Platinen zurückzugreifen, so dass ein weiterer Vorteil schließlich in der erleichterten Einbringbarkeit in ein gemeinsames Gehäuse sowie Verbaubarkeit innerhalb begrenzter Einbauräume liegt.

Zur Verbesserung der thermischen Anbindung, insbesondere der wärmeerzeugenden, zumeist hochkomplexen Bauteile, beispielsweise an eine Fahrgastzelle, weist wenigstens die erste Platine, vorzugsweise aber auch die zweite Platine, thermische Pads oder Vias auf. Eine derartig gute Wärmeleitung im Trägermaterial führt in vorteilhafter Weise zu einer gleichmäßigeren Temperaturverteilung innerhalb der Schaltkreise. Zur Gewährleistung eines Solltemperaturbereichs insb. der optischen Bauelemente wird vorgeschlagen, bevorzugt sog. Peltier-Elemente zu verwenden. Da Peltier-Elemente auch zur Erhöhung der Temperatur geeignet sind, sind sie konventionellen Kühltechniken weit überlegen. Insbesondere ermöglichen sie in vorteilhafter Weise eine hohe Kühlleistung auf kleinstem Raum und höchste Temperaturgenauigkeit.

Vorzugsweise ist mittig zentriert über dem optischen Bildaufnahmesensor eine Optik starr angeordnet. Diese kann nach einer Weiterbildung der Erfindung mit einem eigenen Gehäuse oder einer Halterung vormontiert sein, was in vorteilhafter Weise besondere Gehäuseausprägungen für die Optik, wie sie im Stand der Technik anzutreffen sind, reduziert.

Erfindungsgemäß bevorzugt ist zumindest die erste Platine nach der sog. Chip-on-Board und/oder Flip-Chip-Technik gefertigt bzw. bestückt. In der Chip-on-Board-Technik (COB) werden die Halbleiter-Bauelemente auf der Leiterplatte montiert, kontaktiert und vergossen. Die Hauptvorteile dieser Integrationstechnik sind neben der platzsparenden Aufbautechnik und Gewichts-Reduzierung die hohe Flexibilität.

In der Flip-Chip-Technik werden ungehäuste ICs (Die) kopfüber auf dem Substrat montiert und gleichzeitig über Gold-, Lotoder Klebstoffbumps elektrisch kontaktiert. Auf diese Weise lassen sich hohe Packungsdichten erzielen. Besonders interessant ist die Low-cost Flip-Chip-on-Board-Technik, welche mit der Oberflächenmontagetechnik (SMT) kombinierbar ist. So folgt aus der hohen Verwandtschaft zur Standard SMT-Technologie ein erhebliches Kosteneinsparungspotential: selbst "gebumpte" Flip-Chips sind in der Beschaffung zudem kostengünstiger als entsprechend gehäuste Integrierte Schaltungen (IS).

Erfindungsgemäß bevorzugt weist die erste Platine mehrere Lagen für Verbindungen und definierte Impedanzen auf. Durch die flächige Verteilung der Anschlüsse entsteht vorteilhaft eine optimale Packungsdichte und Verarbeitungsgeschwindigkeit. Die Mehrlagen-Technik erlaubt zudem in vorteilhafter Weise die weitere Entflechtung von Halbleiterschaltkreisen auf engem Raum.

Erfindungsgemäß bevorzugt sind die erste und die zweite Platine zueinander geneigt angeordnet, indem bevorzugt die Grundplatte einen entsprechenden Neigungswinkel α aufweist. Durch die Neigung ist in vorteilhafter Weise das Gehäuse der Kamera mit einfachen Mitteln auch gekrümmten Oberflächen anpassbar. Die Neigung α kann einen beliebigen Winkel aufweisen.

Die erfindungsgemäße Bilderzeugungsvorrichtung zeichnet sich bevorzugt durch eine dritte, vorzugsweise zwischen und/oder seitlich der Optiken angeordneten, Platine aus, welche eine Beleuchtungseinheit, beispielsweise matrixförmig angeordneten LED-Elemente trägt. Die Leuchtdioden dienen beispielsweise der Bestrahlung eines Fahrzeugssitzes. Vom Fahrzeugsitz bzw. einem charakteristischen Element des Sitzes oder einem Objekt auf dem Sitz reflektierte Strahlen werden vom optischen Bildaufnahmesensor aufgenommen. Damit ist beispielsweise die Erkennung der Position eines Insassen auf dem Fahrzeugsitz oder aber eine Abtastung einer Gefahrenzone vor einem zusammengefalteten Airbag ermöglicht.

Erfindungsgemäß bevorzugt ist die dritte Platine durch das Gehäuse für die Optik und/oder durch eine separate Halterung gehaltert, wobei das Optikgehäuse und/oder die Halterung bevorzugt durch Metallisierung zumindest an ihrer Oberfläche eine elektrische Verbindung zwischen der Beleuchtungseinheit und z.B. der erster Platine herstellt.

Zwecks thermischer Isolation der ersten Platine gegenüber dem LED-Beleuchtungsmodul wird vorgeschlagen, zwischen erster und dritter Platine ein geeignetes Isolationsmedium, insbesondere einen thermischen Schirm, beispielsweise eine Wärmestrahlung abweisende Folie, anzuordnen.

Aus Gründen der Kostenersparnis wird vorgeschlagen, die zweite und/oder dritte Platine in einer kostengünstigeren Platinen-Technik als die erste Platine auszubilden, wozu sich beispielsweise sog. FR4-Techniken anbieten. Insbesondere kann die dritte Platine, aber auch die zweite Platine, eine sog. Metalleiterplatine sein, beispielsweise also aus Aluminium oder Kupfer bestehen oder dieses Materialien enthalten, welche die Wärmebildung durch die LED-Optik in vorteilhafter Weise geeignet abzuführen hilft.

Erfindungsgemäß bevorzugt erfolgt, z.B. nach dem Aushärten eines Klebers, in einem zusätzlichen Arbeitsschritt das Verbinden der Chipanschlüsse mit der Leiterplatte bzw. Platine und der ersten und/oder zweiten und/oder dritten Platine untereinander mittels eines, aus der IC-Herstellung bekannten, sog. Wire-Bonders. Durch die wire-bond-Technik, d.h. dem setzen sog. Bonddrähtchen, kann in vorteilhafter Weise zum einen auf platzraubende SMD-Steckverbindungen verzichtet werden. Zum anderen liegt ein weiterer Vorteil hierbei in der erhöhten Verbindungssicherheit. So ist kein Vertauschen, keine Durchkontaktierung für Steckerpins, kein Wellenlöten (falls nicht als SMD-Stecker) mehr möglich bzw. nötig. Durch die Reduzierung schaltungsinterner Verbindungsstellen wird zudem die Zuverlässigkeit der Bilderzeugungsvorrichtung erhöht.

Zum Schutz vor äußeren Einflüssen wird vorgeschlagen, die Bauteile und/oder deren Bonddrahtanschlüsse mittels einer nicht elektrisch leitenden Vergussmasse, beispielsweise einer Kunststoffmasse (Glop-Top), zu umgeben.

Alle Bestückungs- sowie Montagevorgänge der erfindungsgemäßen Bilderzeugungsvorrichtung können bevorzugt in der Hybridfertigung unter Reinraumbedingungen durchgeführt werden. Ein Zwischenschritt zur Montage der optischen Bildaufnahmesensoren auf Flex-Folie kann damit in vorteilhafter Weise entfallen.

Die Bilderzeugungsvorrichtung nach der Erfindung eignet sich insbesondere als integrales Bauteil für im Außenspiegel angeordnete Spurwechselassistenten oder im Dachhimmel angeordnete Insassenerkennungseinrichtungen eines Kraftfahrzeuges.

Zusätzliche Einzelheiten und weitere Vorteile der Erfindung werden nachfolgend an Hand bevorzugter Ausführungsbeispiele in Verbindung mit der beigefügten Zeichnung beschrieben.

Darin zeigen schematisch:
- Fig. 1: eine Mono-Bilderzeugungsvorrichtung nach der Erfindung;
- Fig. 2: ein 3D-Bilderzeugungsvorrichtung nach der Erfindung;
- Fig. 3: die 3D-Bilderzeugungsvorrichtung nach Fig. 2 mit einer abgewinkelten Grundplatte ohne Gehäuseteile; und
- Fig. 4: die 3D-Bilderzeugungsvorrichtung nach Fig. 3 mit einem großflächigeren Beleuchtungs-Modul als in Fig. 3.

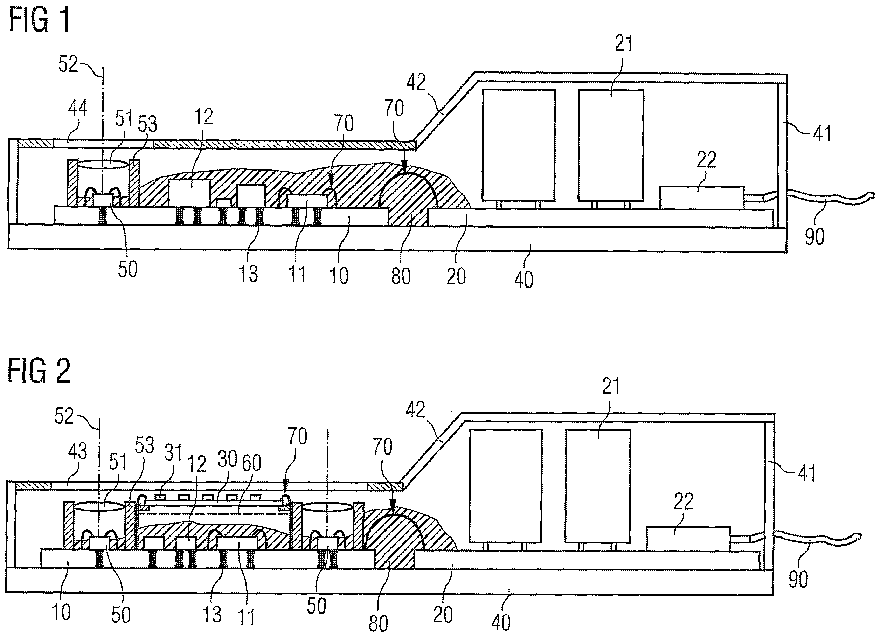

Fig. 1 zeigt schematisch eine Mono-Bilderzeugungsvorrichtung, insb. Mono-Kamera, 1 nach der Erfindung. Auf einer ersten, insb. starren, Platine 10 sind erfindungsgemäß alle hochkomplexen Bauteile der Kamera 1 angeordnet, also insbesondere ein Mikro-Controller 11 sowie verschiedene Speicherelemente 12 oder dergleichen. Links neben den Speicherelementen 12 befindet sich ein optischer Bildaufnahmesensor 50, beispielsweise ein sog. CMOS-Bildaufnahmesensor. Obwohl prinzipiell auch andere Sensortypen wie beispielsweise CCD-Sensoren (CCD = Charge Coupled Device / ladungsgekoppeltes Bauelement) in Frage kommen, bietet die Verwendung eines CMOS-Sensors eine Reihe von Vorteilen. Ein CMOS-Sensor weist in der Regel eine geringere Leistungsaufnahme als beispielsweise ein CCD-Sensor auf. Weil beim CMOS-Sensor keine Ladungen über lichtempfindliche Sensoroberflächen transportiert werden müssen, tritt der sogenannte Smear-Effekt nicht auf, der als äußerst nachteilig angesehen wird. Beim CMOS-Sensor ist in der Regel weiterhin ein wahlfreier Pixelzugriff möglich. Im Gegensatz hierzu können bei CCD-Sensoren üblicherweise nur einzelne Zeilen ausgelesen werden. Oberhalb des Bildaufnahmesensors 50 ist eine Optik 51 angeordnet. Bildaufnahmesensor 50 und Optik 51 liegen auf einer gemeinsamen optischen Achse 52, welche beispielsweise in den Innenraum eines Kraftfahrzeuges - zeichnerisch nicht dargestellt - gerichtet ist. Die Optik 51 wird von einem Gehäuse 53 gehaltert. Dieses 53 ist an der ersten Platine 10 befestigt, vorzugsweise geklebt. Optik 51 und Gehäuse 53 werden, vorzugsweise zu einem Optikmodul vormontiert, auf der Platine 10 bestückt. Benachbart der ersten Platine 10 ist erfindungsgemäß eine zweite Platine 20 angeordnet, auf welcher alle anderen Bauteile als die hochkomplexen Halbleiter (Die) angeordnet sind, also insbesondere Kondensatoren, Transistoren, Widerstände, Spulen 21 oder SMD-Stecker 22, wobei letzterer eine Kabelverbindung 90 zu externen Auswerteeinheiten oder dergleichen ermöglicht.

Die erste Platine 10 ist bevorzugt nach der sog. Chip-on-Board-Technik gefertigt bzw. bestückt und weist beispielsweise bis zu sechs oder acht Lagen auf. In der Platine 10 eingebrachte thermische Pads, Vias oder sog. Peltier-Elemente 13 helfen, die Thermik in die Grundplatte 40 zu führen. Bei der Auswahl des Substratmaterials für die Platine 10 ist besonderes Augenmerk auf die Unterschiede in den Wärmeausdehnungskoeffizienten zwischen den Chips 11, 12, etc. und dem Substrat zu legen. Verwendung finden insbesondere verschiedene Keramikarten, aber auch FR4 für Chip-on-Board. Zur weiteren Optimierung der Wärmeableitung können zumindest teilweise die Kontaktstellen der Bauelemente (Die) und Platine mit zusätzlichen Durchkontaktierungen (Via Holes) ausgeführt sein.

Die zweite Platine 20 besteht bevorzugt aus einem sog. FR4-Substrat und kann wie die ersten Platine 10 ebenfalls thermische Pads, Vias oder sog. Peltier-Elemente (nicht dargestellt) aufweisen. Die zweite Platine 20 kann aber auch eine sog. Metalleiterplatine sein. Sie weist beispielsweise zwischen zwei und vier Lagen auf, also deutlich weniger als die erste Platine 10. Beide Platinen 10 und 20 sind auf einer Grundplatte 40 angeordnet, insbesondere eingeklebt. Die vorzugsweise metallische, insb. Aluminium und/oder Kupfer enthaltende, Grundplatte 40 sorgt neben einer verbesserten Wärmeableitung insbesondere für eine zusätzlich gute Steifigkeit und Ebenheit der Platinen 10 und 20 und damit auch für eine korrekte Ausrichtung der optischen Achsen 52. Wie die Bauteile 11, 12, etc. sind auch die beiden Platinen 10 und 20 untereinander vorzugsweise mittels sog. Bonddrähte 70 elektrisch verbunden. Bauteile 11, 12, etc. und/oder die Bonddrähte 70 sind bevorzugt mittels einer elektrisch isolierenden Vergussmasse 80 vor äußeren Einflüssen geschützt. Die auf der Grundplatte 40 angeordneten Baueinheiten lassen sich einfach und problemlos in ein geeignetes Gehäuse 41 einbringen. Der Gehäusedeckel 42 weist mittig zentriert oberhalb der optischen Achse 52 eine Öffnung auf, in welcher in einer einfachsten Ausgestaltung eine optisch durchlässige Scheibe 43, beispielsweise aus Glas, angeordnet ist. Vorzugsweise ist die Scheibe 43 an das Design des Kraftfahrzeuges angepasst, beispielsweise entsprechend eingefärbt. Im vorstehend erläuterten Zusammenhang kann bei der Bilderzeugungsvorrichtung 1 nach der Erfindung auch ein optischer Filter 44 vorgesehen sein. Bevorzugt weist die Scheibe 43 selbst Filtereigenschaften auf. Gehäuse 41, Gehäusedeckel 42 und Scheibe 43 bzw. Filter 44 sind bevorzugt einstückig ausgebildet bzw. zu einer Gehäuseeinheit vormontiert.

Fig. 2 zeigt eine 3D-Bilderzeugungsvorrichtung, insb. eine 3D-Kamera, 1 nach der Erfindung. Gegenüber der in Fig. 1 abgebildeten Mono-Kamera 1 weist die 3D-Kamera 1 zwei, vorzugsweise vormontierte, Optikmoduln 50, 51, 52, 53 auf, welche insoweit bevorzugt vorjustierte Einheiten darstellen. Zwischen den Optikmoduln ist eine weitere, dritte Platine 30 beispielsweise aus einem FR4-Substrat oder bevorzugt als Metall-Leiterplatte ausgebildet angeordnet. Diese trägt eine Beleuchtungseinheit 31, beispielsweise matrixförmig angeordnete lichtemittierende Dioden bzw. Lumineszenzdioden, sog. LED-Elemente. Die dritte Platine 30 ist über entsprechende Halter 32 oberhalb der ersten Platine 10 fixiert. An Stelle der Halter 32 können auch die Optikgehäuse 53 diese Aufgabe übernehmen. Zwecks thermischer Isolation der ersten Platine 10 gegenüber dem LED-Feld 31 ist zwischen erster 10 und dritter 30 Platine ein thermischer Schirm 60, beispielsweise eine Wärmestrahlung abweisende Folie, angeordnet. Oberhalb der Optiken 51 weist der Gehäusedeckel 42 eine optisch durchlässige Scheibe 43 oder einen geeigneten optischen Filter 44 auf.

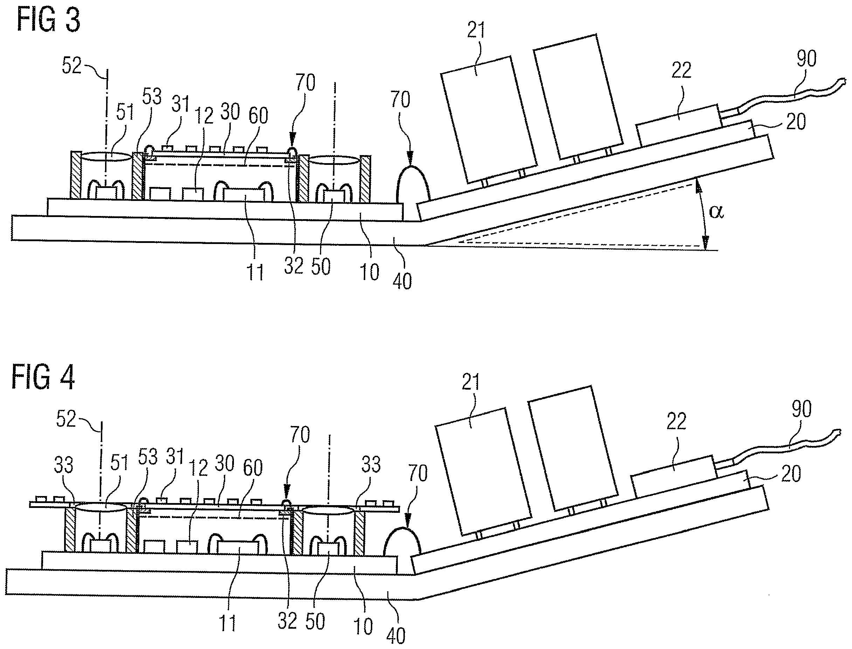

Fig. 3 zeigt die 3D-Bilderzeugungsvorrichtung bzw. 3D-Kamera 1 nach Fig. 2 mit einer abgewinkelten Grundplatte 40 ohne Gehäuse und Vergussmasse. Der Neigungswinkel α zwischen erster 10 und zweiter Platine 20 bzw. von der Grundplatte 40 kann letztlich beliebig sein. Die Neigung α muss freilich nicht, wie gezeichnet, innerhalb einer Ebene liegen, sie kann sich auch in einen dreidimensionalen Raum hinein erstrecken. Deutlich erkennbar jedoch ist, wie aufgrund der Neigung α in vorteilhafter Weise das Gehäuse der Kamera 1 an den Verlauf einer gekrümmten Oberfläche angepasst werden kann.

Fig. 4 zeigt die 3D-Bilderzeugungsvorrichtung 1 nach Fig. 3. Gegenüber dem Ausführungsbeispiel nach Fig. 3 zeigt Fig. 4 ein großflächigeres Beleuchtungs-Modul 31, welches sich nicht nur zwischen sondern auch seitlich der Optik 51 erstreckt. Um die Optik 51 nicht zu stören, weist die Platine 30 im Bereich der Optik 51 eine Aussparung 33 auf.

Die Zeichnung verdeutlicht, wie die erfindungsgemäße Bilderzeugungsvorrichtung 1 zumindest im Bereich ihrer Optikmoduln (50, 51, 52, 53) eine minimale Bauhöhe aufweist, weshalb sich die erfindungsgemäße Bilderzeugungsvorrichtung 1 insbesondere für Einbauten als Insassenerkennungseinheit im Dachhimmel, Spurwechselassistent im Außenspiegel oder dergleichen Anwendungen bzw. Einbauorten in einem Kraftfahrzeug eignet, eben dort, wo extreme Einbauverhältnisses anzutreffen sind und bekannte Kamerasysteme versagen.

## Patentansprüche

1. Bilderzeugungsvorrichtung (1),
**gekennzeichnet durch**
- eine erste Platine (10) für hochkomplexe Halbleiter wie Mikro-Controller (11), Speicher (12), etc. mit wenigstens einen optischen Bildaufnahmesensor (50); und
- eine zweite Platine (20) für alle anderen Bauteile wie insb. große Kondensatoren, Transistoren, Widerstände, Spulen, Stecker etc. (21, 22);
wobei zumindest eine der zwei Platinen (10, 20) auf einer metallischen Grundplatte (40) angeordnet, vorzugsweise eingeklebt, ist,
und wobei die beiden Platinen (10, 20) untereinander elektrisch verbunden sind.

2. Bilderzeugungsvorrichtung (1) nach Anspruch 1, **dadurch gekennzeichnet, dass** wenigstens die erste Platine (10), vorzugsweise auch die zweite Platine (20), thermische Pads, Vias oder sog. Peltier-Elemente (13) aufweist.

3. Bilderzeugungsvorrichtung (1) nach Anspruch 1 oder 2, **dadurch gekennzeichnet, dass** mittig zentriert über dem optischen Bildaufnahmesensor (50) eine, vorzugsweise mit einem Gehäuse (53) oder einer Halterung (32) vormontierte, Optik (51) starr angeordnet ist.

4. Bilderzeugungsvorrichtung (1) nach einem der Ansprüche 1 bis 3, **dadurch gekennzeichnet, dass** zumindest die erste Platine (10) nach der Chip-on-Board- und/oder Flip-Chip-Technik gefertigt bzw. bestückt ist.

5. Bilderzeugungsvorrichtung (1) nach Anspruch 4, **dadurch gekennzeichnet, dass** die erste Platine (10) mehrere Lagen für Verbindungen und definierte Impedanzen aufweist.

6. Bilderzeugungsvorrichtung (1) nach einem der vorherigen Ansprüche, **dadurch gekennzeichnet, dass** die erste (10) und die zweite Platine (20) in einem beliebigen Winkel α zueinander geneigt angeordnet sind.

7. Bilderzeugungsvorrichtung (1) nach einem der vorherigen Ansprüche, **gekennzeichnet durch** eine dritte, vorzugsweise zwischen und/oder seitlich der Optik(en) (51) angeordneten, Platine (30) mit einer Beleuchtungseinheit (31).

8. Bilderzeugungsvorrichtung (1) nach Anspruch 7, **dadurch gekennzeichnet, dass** die dritte Platine (30) durch das Gehäuse (53) für die Optik (51) und/oder eine separate Halterung (32) gehaltert ist, wobei das Optikgehäuse (53) und/oder die Halterung (32) bevorzugt durch Metallisierung zumindest an ihrer Oberfläche eine elektrische Verbindung zwischen der Beleuchtungseinheit (31) und z.B. der erster Platine (10) herstellt.

9. Bilderzeugungsvorrichtung (1) nach Anspruch 7 oder 8, **dadurch gekennzeichnet, dass** zwischen erster (10) und dritter (30) Platine ein thermisches Isolationsmedium (60), insbesondere ein thermischer Schirm (60), angeordnet ist.

10. Bilderzeugungsvorrichtung (1) nach einem der vorherigen Ansprüche, **dadurch gekennzeichnet, dass** die zweite (20) und/oder dritte (30) Platine eine FR4- oder Metall-Leiterplatte ist.

11. Bilderzeugungsvorrichtung (1) nach einem der vorherigen Ansprüche, **dadurch gekennzeichnet, dass** das Verbinden der Chipanschlüsse mit der Platine (10; 20; 30) und das Verbinden der ersten (10) und/oder zweiten (20) und/oder dritten (30) Platine untereinander mittels Bonddrähte (70) erfolgen.

12. Bilderzeugungsvorrichtung (1) nach einem der vorherigen Ansprüche, **dadurch gekennzeichnet, dass** die Bonddrähte (70) und/oder dazu benachbarte Bauteile (11; 12; etc.) mittels einer Vergussmasse (80) vor äußeren Einflüssen geschützt sind.

## Claims

1. An image generation device (1),
**characterized by**
- a first printed circuit board (10) for highly complex semiconductors such as a microcontroller (11), memory (12), etc. with at least one optical image recording sensor (50); and
- a second printed circuit board (20) for all other components such as, in particular, large capacitors, transistors, resistors, coils or plugs, etc. (21, 22);
wherein at least one of the two printed circuit boards (10, 20) is arranged on, preferably glued to, a metallic base plate (40),
and wherein the two printed circuit boards (10, 20) are electrically interconnected.

2. The image generation device (1) according to Claim 1, **characterized in that** at least the first printed circuit board (10), preferably also the second printed circuit board (20), has/have thermal pads, vias, or so-called Peltier elements (13).

3. The image generation device (1) according to Claim 1 or 2, **characterized in that** rigidly located centrally above the optical image-recording sensor (50) are optic means (51) which are preferably pre-assembled together with a housing (53) or a retention device (32).

4. The image generation device (1) according to any one of Claims 1 to 3, **characterized in that** at least the first printed circuit board (10) is produced or equipped in accordance with chip-on-board and/or flip-chip technology.

5. The image generation device (1) according to Claim 4, **characterized in that** the first printed circuit board (10) has a plurality of layers for connections and defined impedances.

6. The image generation device (1) according to any one of the preceding claims, **characterized in that** the first printed circuit board (10) and the second printed circuit board (20) are located inclined at any angle α with respect to one another.

7. The image generation device (1) according to any one of the preceding claims, **characterized by** a third printed circuit board (30) having an illuminating unit (31), wherein said third printed circuit board (30) is preferably arranged between and/or to the side of the optics means (51).

8. The image generation device (1) according to Claim 7, **characterized in that** the third printed circuit board (30) is retained by the housing (53) for the optics means (51) and/or a separate retention device (32), with the optics housing (53) and/or the retention device (32) establishing, preferably by means of metal plating at least on the surface thereof, an electrical connection between the illuminating unit (31) and e.g. the first printed circuit board (10).

9. The image generation device (1) according to Claim 7 or 8, **characterized in that** a thermal insulating medium (60), in particular a thermal shield (60), is arranged between the first printed circuit board (10) and the third printed circuit board (30).

10. The image generation device (1) according to any one of the preceding claims, **characterized in that** the second printed circuit board (20) and/or third printed circuit board (30) is/are an FR4 circuit board or a metal circuit board.

11. The image generation device (1) according to any one of the preceding claims, **characterized in that** the chip terminals are connected to the printed circuit board (10; 20; 30) by means of bond wires (70), and the first printed circuit board (10) and/or the second printed circuit board (20) and/or the third (30) printed circuit board are interconnected by means of bond wires (70).

12. The image generation device (1) according to any one of the preceding claims, **characterized in that** the bond wires (70) and/or components (11; 12; etc.) adjacent thereto are protected from external influences by means of a sealing compound (80).

## Revendications

1. Dispositif de formation d'image (1)
**caractérisé par**
- une première platine (10) pour des semi-conducteurs très complexes, tels que microcontrôleur (11), mémoire (12), etc., avec au moins un capteur de prise de vues (50) optique ; et
- une deuxième platine (20) pour tous les autres composants tels que notamment condensateurs de grandes dimensions, transistors, résistances, bobines, connecteurs, etc. (21, 22) ;
au moins une des deux platines (10, 20) étant disposée, de préférence collée, sur une plaque de base (40) métallique, et les deux platines (10, 20) étant raccordées électriquement l'une à l'autre.

2. Dispositif de formation d'image (1) selon la revendication 1, **caractérisé en ce qu'**au moins la première platine (10), de préférence également la deuxième platine (20), présente des pads thermiques, des traversées ou ce qu'on appelle des éléments Peltier (13).

3. Dispositif de formation d'image (1) selon la revendication 1 ou 2, **caractérisé en ce qu'**une optique (51), centrée de façon médiane au-dessus du capteur de prise de vues (50) optique, de préférence pré-montée avec un boîtier (53) ou un élément de retenue (32), est disposée de façon rigide.

4. Dispositif de formation d'image (1) selon l'une des revendications 1 à 3, **caractérisé en ce qu'**au moins la première platine (10) est fabriquée ou équipée selon la technique chip-on-board et/ou flip-chip.

5. Dispositif de formation d'image (1) selon la revendication 4, **caractérisé en ce que** la première platine (10) présente plusieurs couches pour des raccordements et des impédances définies.

6. Dispositif de formation d'image (1) selon l'une quelconque des revendications précédentes, **caractérisé en ce que** la première platine (10) et la deuxième platine (20) sont disposées en étant inclinées l'une par rapport à l'autre selon un angle α quelconque.

7. Dispositif de formation d'image (1) selon l'une quelconque des revendications précédentes, **caractérisé par** une troisième platine (30), de préférence disposée entre et/ou sur le côté de l'optique/des optique(s) (51), avec une unité d'éclairage (31).

8. Dispositif de formation d'image (1) selon la revendication 7, **caractérisé en ce que** la troisième platine (30) est retenue par le boîtier (53) pour l'optique (51) et/ou par un élément de retenue (32) séparé, le boîtier (53) optique et/ou l'élément de retenue (32) réalisant, de préférence par métallisation, au moins sur sa surface un raccordement électrique entre l'unité d'éclairage (31) et par exemple la première platine (10).

9. Dispositif de formation d'image (1) selon la revendication 7 ou 8, **caractérisé en ce que**, entre la première platine (10) et la troisième platine (30), il est disposé un agent thermiquement isolant (60), en particulier un écran thermique (60).

10. Dispositif de formation d'image (1) selon l'une quelconque des revendications précédentes, **caractérisé en ce que** la deuxième platine (20) et/ou la troisième platine (30) est un circuit imprimé FR4 ou métallique.

11. Dispositif de formation d'image (1) selon l'une quelconque des revendications précédentes, **caractérisé en ce que** le raccordement des connexions de puce à la platine (10 ; 20 ; 30) et le raccordement de la première platine (10) et/ou de la deuxième platine (20) et/ou de la troisième platine (30) entre elles s'effectue au moyen de fils de connexion (70).

12. Dispositif de formation d'image (1) selon l'une quelconque des revendications précédentes, **caractérisé en ce que** les fils de connexion (70) et/ou des composants (11 ; 12 ; etc.) qui en sont voisins sont protégés d'influences extérieures au moyen d'une masse de scellement (80).
